(19) Europäisches Patentamt
European Patent Office
Office européen des brevets

(11) **EP 2 230 523 B1**

(12) **EUROPEAN PATENT SPECIFICATION**

(45) Date of publication and mention
of the grant of the patent:
**08.02.2017  Bulletin 2017/06**

(51) Int Cl.:
***G01R 29/14*** *(2006.01)*

(21) Application number: **09290213.9**

(22) Date of filing: **20.03.2009**

(54) **Physical quantity measuring unit and device for measuring a voltage and an electric field**

Physikalische Grössenmessvorrichtung und Vorrichtung zum Messen von Spannung und elektrischen Feldern

Unité de mesure d'une quantité physique et dispositif pour mesurer une tension et un champ électrique

(84) Designated Contracting States:
**AT BE BG CH CY CZ DE DK EE ES FI FR GB GR HR HU IE IS IT LI LT LU LV MC MK MT NL NO PL PT RO SE SI SK TR**

(43) Date of publication of application:
**22.09.2010  Bulletin 2010/38**

(73) Proprietors:
• **SYSNAV**
**27200 Vernon (FR)**
• **L'Université de Caen Basse-Normandie**
**14032 Caen (FR)**

(72) Inventor: **Robbes, Didier**
**14480 Lantheuil (FR)**

(74) Representative: **Grünecker Patent- und Rechtsanwälte**
**PartG mbB**
**Leopoldstraße 4**
**80802 München (DE)**

(56) References cited:
**WO-A-03/048789    WO-A-2009/036989**

**Description**

The present invention relates to a measuring unit of physical quantities in which the physical quantity is converted in electrical ones by the means of a first and second sensactor. The invention furthermore relates to a probe and a sensor for measuring electrical fields with a large bandwidth, including very low frequencies, high dynamic range and linearity, without making electrical contacts.

A physical quantity having a scalar character is represented by a number and an attached unit; the number may vary from point to point of the ordinary 3D space and it may have a time variation. Given the local environment where the physical quantity is considered, the spatial variation is continuous in vacuum or homogenous matter, and that variation is usually characterised using the mathematical concept of "gradient", which becomes a vector quantity, due to the need of three numbers to specify a direction of the ordinary 3D space.

The present invention relates to pairs of sensors of scalar physical quantities, arranged in the known gradiometric combination, which procures a measure of one component of the gradient along a specified oriented axis. One example of a scalar physical quantity is the electrical potential, whereas its gradient is the electrical field. Another one is the temperature, the attached gradient of which is the heat transported through conduction mechanism.

The feedback theory of linear circuits and systems introduces three main functional features between the input and output signals of a servo-loop: an error detection giving the difference between the system input and output, a signal amplification of that error signal, and a feedback unit which picks up the output signal in order to drive the error detection unit. According to the conventional feedback theory, many advantages are obtained, especially good linearity, dynamic range, and bandwidth of the closed loop system versus those of the open loop ones. Furthermore, a better immunity to gain variations and ageing of the signal amplification chain is obtained, in the sense that at very large forward gain values, the overall, closed loop, system transfer function between input and output becomes mainly dependent on the return feedback chain, chosen in such ways and technologies that they are less sensitive to parameters inducing forward gain variations.

Besides that feedback process in simple one input - one output circuits, analog signal processing is known that starts around differential topologies dealing with comparison between two signals, which means both of these signals are composed of a common component to which a differential component is added. Typically, only the differential component is relevant to the user, and detecting units and amplifiers that are following differential sensors provide a strong amplification of the signal difference and try to keep the common mode amplification as low as possible. In this context V. Frick et al. "CMOS Microsystem for AC current measurement with galvanic isolation", Proceedings of IEEE Sensors 2002, Orlando, FL; IEEE International Conference on Sensors, New York, NY,: IEEE, US, vol. 2, 12 June 2002, pages 1445-1450, XP010605334, describes a circuit to reject the common mode.

In addition, many physical principles of sensors lead to practical devices having at least two electrical contacts, and for which a functional relationship exists between a physical quantity X and a pair of electrical variables: voltage and current (resistive sensors), or electrical charge and voltage (capacitive sensors), or magnetic flux and current (inductive sensors), that can be defined between the two electrodes. Two such terminal devices, known as controlled dipoles, can be arranged in various bridge configurations, including the conventional Wheatstone bridge, to provide sensors with a differential output.

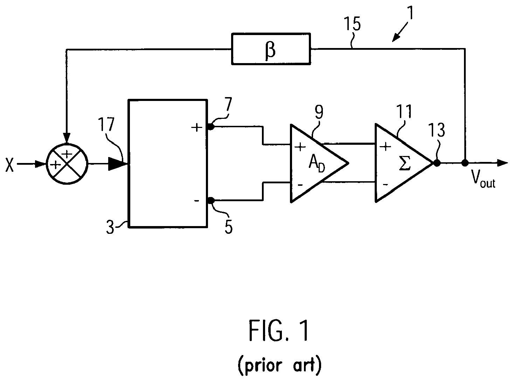

Scientific measuring instruments are making use of sensors to measure physical quantities to a certain degree of accuracy, and good results are obtained by mixing both of the abovementioned techniques, that are differential amplification and feedback. Figure 1 illustrates a prior art circuit 1, comprising a sensing means 3 for a physical unit X with differential outputs 5 and 7 which in turn are linked with the inputs of a fully differential amplifier 9. After amplification, a summing means 11 carries out a differential to non differential signal conversion. The output 13 ($v_{out}$) of the summing means 11 is then fed back via a single feed back line 15 and adds to the physical quantity X to be measured. Thus the input 17 of the measuring device 3 receives the combined signal X+ß*$v_{out}$. Here ß corresponds to a feedback transfer parameter. It should be noticed that, to apply the feedback, an additional device must be introduced to convert electrical quantities in amounts of the physical quantity, introduced at the sensor input and superimposed to the physical quantity that is measured. Such a device has the generic name of transducer. The association of a sensor and a transducer is known as sensactor.

In the case of a bolometer, as another example of physical quantity measuring unit, the usual scheme to return the input physical quantity, here heat, is produced by Joule effect obtained by passing an electrical current through a coil. Here, the bolometer temperature is the scalar physical quantity whose gradient is the heat flux.

In the case of conventional electrometers very small currents are measured to render the measurement of an electric field possible. The electrometers have an ultra high input impedance in order to minimize the influence of the measurement on the field to be measured.

Electric field measurements that require electrical contact are often not possible or desirable, for example in the field of geophysics (mining prospecting, hydrography), biomedical techniques (general electrophysiology, electrocardiography, and electroencephalography), the measuring of electromagnetic fields, the detection of moving objects and for educational purposes.

The international patent application WO 03/048789 describes an example of an electrodynamic sensor that does not need electrical contact with an object under test. The sensor has two probes connected to an electrometer. The electrometer comprises a differential amplifier and high input impedance so that little power is drawn from the received field. The high input impedance is obtained by combining different circuit techniques, such as guarding, bootstrapping and neutralisation.

The international patent application WO 09/036989 was published after filing of the present application and discloses a further differential amplifier without disclosing a feedback loop using the common mode.

Improvements of sensors known from the prior art are desirable where sensitivity, bandwidth and the measurement of fields with very low frequencies down to static fields are concerned. Further improvement of performance can be obtained when the disturbance of the physical quantity to be measured by the probe can be reduced.

The object of the present invention is to provide a measuring unit for scalar physical quantities and for their associated gradient, with improved properties.

This object is achieved with the physical quantity measuring unit, in particular a measuring unit of both a scalar physical quantity and its gradient, according to claim 1 comprising: a sensing means comprising a first and a second sensactor wherein the first sensactor is configured to provide a first output and comprises a first and second feedback input and the second sensactor is configured to provide a second output and comprises a third and fourth feedback input, a fully differential amplifier means comprising differential outputs and a common mode output, wherein the first and second output of the sensing means is connected to a first input and a second input of the fully differential amplifier means respectively, two feedback loops connecting the differential outputs of the fully differential amplifier means to the first and third feedback inputs with a signal sign inversion, and a third feedback loop connecting the common mode output of the fully differential amplifier means with the second and fourth feedback inputs of the sensing means.

In this context the first and third feedback inputs are also called balancing inputs and the second and fourth feedback inputs are also called common mode inputs. Like already mentioned above a sensactor relates to a means providing a sensor and an actuator, like a transducer.

With this inventive circuit topology, the two fundamental modes of the involved signals, known as the common mode and the differential mode, are simultaneously subjected to a multi-source and multi-loop feedback process which is in complete contrast to the prior art circuits, where only a single loop - single source feedback process is applied, like described above and illustrated in Figure 1.

It is important to mention that the novel circuit topology is in particular dedicated to the measuring of strongly coupled pairs of physical quantities (a scalar one and its gradient component on a specified axis), like electric potential and field, temperature and conduction heat flux, particles density and diffusion currents etc.

Another important feature of dealing simultaneously with a scalar physical quantity together with its gradient using the innovative topology is that they appear respectively as the common mode signal and the differential mode signal that are processed by the sensactor pair of the sensing means and the amplifier, a situation that differs from the prior art, where only the differential mode is significant to the user and the common mode is associated to a parasitic signal to be rejected by the measuring electronics.

In this context, due to the fully differential amplifier which provides a large separation of the common and differential modes by the means of three electrical outputs, one dedicated to the common mode and two dedicated to the differential mode, three electrical sources are available to drive the second and fourth inputs of the common mode sensactor pair inputs together with first and third inputs of the balanced sensactor inputs. The use of three control sources compared to only one in the prior art and the separation of modes which implies a separation between the control sources of the three simultaneous feedback loops, allows a stable overall process together with the improvements provided by feedback in terms of bandwidth, dynamic range, and linearity.

Preferably, the unit can further comprise a differential amplifier between a common mode output of the fully differential amplifier means and the second and fourth feedback inputs of the sensing means. The use of an amplifier between common mode output and the second and fourth inputs of the sensing means provides the needed phase reversal for stability and procures further gain to obtain a large open loop gain of the feedback loop dedicated to the common mode.

According to an advantageous embodiment, the signal sign inversion of the differential feedback loops can be provided by a simple wiring reversal between the output of the fully differential amplifier means and the first and third inputs of the sensing means. This direct sign inversion without intervening additional electronic devices, like switches etc., greatly simplifies the structure of the unit.

As commonly done around the conventional operational amplifier operated in linear configuration, with strong negative feedback, the innovative topology supports simple rules to obtain the relationship between the two inputs, the value $e$ of the scalar physical quantity X evaluated at point (P) and its gradient component upon one axis supporting the unit vector $\vec{u}$ and which writes $\overline{grad}X \cdot \vec{u}$, and the outputs that are just the three simple sources provided by the three feedback loops introduced above, applied at the sensactor's pair inputs.

In a feedback process an error signal $\varepsilon$ is formed between the input signal and the returned (feedback) signal, and the higher the gain of the open loop configuration, the smaller the error signal of the closed loop configuration. The limiting case of so called "total feedback" has a null error signal. Then one assumes that $\varepsilon = 0$, to get the link between the input value and the returned one which then exactly balance the input.

In the multi-source multiloop process according to this invention, two linearly independent error signals may be identified, allowing simple rules to get both the input $e$ and $\overline{gradX} \cdot \vec{u}$ values through the measure of the feedback ones.

In this first variant, these error signals are formed by the superimposition of the values $e^+$ and $e-$ of the input scalar physical quantity and of the locally changed amounts of that physical quantity, before their conversion in electrical signals by the sensors.

According to a preferred embodiment, the unit can further comprise a signal summing means with an inverting input, preferably an amplifying signal summing means. The inputs of the signal summing means are coupled to the outputs of the amplifier means so that, at the output of the signal summing means, with inverting input, the information about the gradient of the scalar unit is obtained.

Preferably, the first and second sensactor can have the same properties, in particular essentially have the same transfer parameter ($\alpha$) and feedback transfer parameters $\beta$ concerning the differential feedback and $\beta_{mc}$ concerning the common mode feedback. In this case, a better separation of common mode and differential modes are provided.

According to a preferred embodiment, the unit can be configured such that the parameters $|\alpha\beta A_D| \gg 1$ and $|\alpha\beta_{MC}G_{MC}| \gg 1$ with $A_D$ being the differential gain of the fully differential amplifier means and $G_{MC}$ the differential gain of the differential amplifier. Under this configuration, this allows the strong feedback limit reached where simplifying rules apply.

According to preferred embodiments of the invention, the sensing means can be configured such that the error signal forming from the first to third feedback loop can be inputted before or after the conversion of the physical quantity into an electric signal.

In the first variant, the feedback signals are thus converted back to quantities of the to be measured physical unity. This has the advantage to include the sensor part of the sensactor pair in the feedback loops, which then benefits of the advantages of the feedback. This is particularly useful whenever the conversion from physical quantity to electrical signal is not linear.

In the second variant, the actuator part is reduced to rather simple signal treatment using common electronic components and techniques to allow a good matching between the amplifiers output and the forming of both the feedback and the error signals, which are dependent on the exact nature of the sensors output: currents or voltage, electrical charges or magnetic flux. In the second variant it is possible to spatially separate the sensing part from the actuator part of the sensing means which then allows a better integration of the feedback signal processing to the measuring unit. In terms of signal processing, the two variants are almost equivalent, except that the sensor part in the second variant does not fully benefit from the feedback, but provides a simplified wiring, and does not need additional means to provide the reverse conversion from an electrical signal into the physical quantity.

The invention also relates to a device for measuring a voltage and an electric field comprising a physical quantity measuring unit as described above and wherein the sensing means comprises a pair of metallic electrodes, in particular metallic plates, more in particular circular metallic plates, each electrode being in connection with the actuating part of the sensactor. In this embodiment the actuators of the sensactor correspond to signal capacitors connected through guarded lines to a very high impedance ($10^{13}\Omega$ or more), electrometer-type amplifier. The pair of electrodes picks up the free voltage of two closely separated regions of free space, i.e. commonly in air, and it is the sensor part of the sensing means.

Here the scalar physical quantity measured is electrical voltage and its gradient, the electrical field, is known to be difficult to measure in the low and very low frequency ranges, in particular below 1 Hz, or even below 1 mHz and without mechanical contacts. The actuating parts of the sensing means needed to get a device according to the topology of the physical quantity measuring unit are provided by three capacitors where the three control electrical quantities are the corresponding voltages applied across these capacitors and the output action resulting from these voltages are the displacement currents, in the conventional meaning of standard theory of electromagnetism.

Preferably, each electrode can be wired to one pin of a signal capacitor $c_s$, one pin of another capacitor $c_d$ and one pin of a high nominal value resistor R, in particular 1G$\Omega$ or more, wherein the second pins of the capacitors $c_s$ are connected to each other and the second pin of the resistor is connected to a reference potential of the measuring unit. The electrodes form each one main node (first and second node), in the conventional meaning of standard circuit theory, and the voltages of the first and second node corresponds to the first and second sensing means outputs. The resistors are furthermore used to bias the inputs of the fully differential amplifier means.

Preferably, the two electrodes can be placed within a distance d, in particular d ranging from about a few $\mu$m to a couple of meters, using an insulating material, in particular with a volume resistivity of $10^{13}$ $\Omega$.m or more. The distance d, is used as a parameter to adjust the electric field sensitivity of the device.

Advantageously, the thickness of the electrodes, in particular the metallic circular plates, can be less than d/2 and/or the square root of the plate is less than d/2. Under these conditions the differential feedback process can be optimized.

Preferably, the device can further comprise an additional capacitor $c_{MC}$, a pin of which is connected at the node linking the signal capacitors $c_s$ while the other pin is connected to the output of the differential amplifier receiving the common mode feedback signal.

In one advantageous embodiment, the capacitances can be grouped around the electrodes. The above-defined nodes are linked to the fully differential amplifier means and to the differential amplifier. The links can be realised using standard lines, preferably coaxial lines or coplanar strip lines. The technique of guarding rings brings the benefit of reducing parasitic capacitance and conductance associated to the line's physical characteristics.

In a variant, the capacitances can be spatially separated from the metallic plates, and are linked to the electrodes using standard lines, preferably coaxial lines or coplanar strip lines. In this case they can be placed directly on the printed circuit board supporting the integrated circuits of the measuring unit. Techniques of guarding should also be applied. This procures the advantage of reducing the number of lines in the vicinity of the electrodes compared to the previous embodiment and corresponds to the second variant of the described measuring unit.

In a variant, the two signal capacitors $c_s$ can be grouped in only one capacitor $c_{s'}$ connecting the two nodes defined above with respect to each electrode and the common mode feedback signal is then applied through two capacitors $c_{MC'}$ instead of one, a pin of each capacitors $c_{mc'}$ being connected to the corresponding node while the other pin is connected to the differential amplifier output.

Preferably, the capacitance $c_s$ can have a value in the range of 1 pF to some nF, the capacitance $c_{md}$ and the capacitance $c_d$ are in the pF range. In these ranges systems with low noise and which function n the strong feedback limit can be realized.

The inventive device furthermore has the advantage that by at most using the guarding technique, none of the other techniques used in the prior art, such as boot strapping or neutralisation, is needed to directly obtain, without contact electrodes, the time variations of voltage in any point of free space together with its associated gradient component over a specified axis.

Advantageously, the device can furthermore comprise a means for vibrating and/or rotating the sensing means. In this case, the device can even determine dc voltage and fields. Thus the inventive voltmeter - electrometer device provides a very low frequency cut-off, down to a few mHz. Mechanical mounts as used in a Theodolite will allow measuring cycles around 100 mHz - 1 Hz to obtain voltage and field values at very low frequency.

Due to the strong feedback limit which is reached in the practical measuring unit it follows a very flat frequency response, both in the voltage and the E-field that holds on a very large bandwidth, starting from the mHz range and in excess of a few hundred Hz.

Transfer coefficient, defined in the bandwidth of the measuring units, are ratios expressed in V/V and V/V.m$^{-1}$ respectively for the measured voltage and the measured electrical field. Their nominal values admit a large available range dependent on the exact electrode's dimensions and spacing together with the capacitors $c_{MC}$ and $c_d$. Because electric fields easily have magnitudes in excess of 1000 V/m, and due to the large dynamic range of the measuring unit (>120dB), an E-field to voltage transfer coefficient in the mV/V.m$^{-1}$ range is a preferred choice to operate in free air and urban or industrial environments. Similar considerations lead to the free space voltmeter transfer coefficient preferably in the range of $10^{-1}$ - $10^{-2}$ V/V.

Advantageous embodiments of the invention will be described in detail and in relation to the accompanying figures.

Figure 1    illustrates a prior art circuit with a single feedback loop,

Figure 2    illustrates a physical quantity measuring unit according to a first embodiment of the invention,

Figure 3    illustrates a sensactor topology according to a second embodiment of the invention,

Figure 4    illustrates a voltmeter - electric fieldmeter according to a third embodiment of the invention,

Figure 5    illustrates the electrical equivalent schematic of the voltmeter - electric fieldmeter according to the third embodiment,

Figure 6    illustrates a variant of the third embodiment, and

Figure 7    illustrates an example of the frequency response of a voltmeter - electric fieldmeter according to the invention.

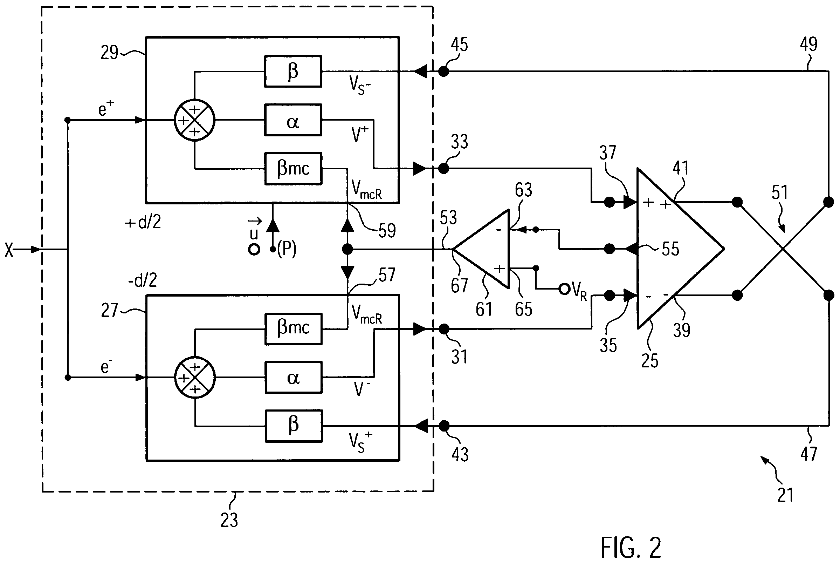

Fig. 2 illustrates a first embodiment of the inventive physical quantity measuring unit 21, which comprises a sensing means 23 which is coupled to a fully differential amplifier means 25. With such a device scalar physical quantities, like voltage or temperature can be determined.

The sensing means 23, comprises a first and a second sensactor 27 and 29. The sensing means 23 comprises a first and second output 31, 33 connected to the first and second input 35, 37 of the fully differential amplifier means 25. The differential outputs 39 and 41 of the fully differential amplifier means 25 are connected with balanced inputs 41 and 45 to form a first and second feedback loop 47, 49 with a signal sign inversion achieved by a wire reversal 51 directly after the amplifier means 25.

In detail, the first feedback loop 47 links the positive output 41 of the differential amplifier means 25 with the balanced input 43, also called the first feedback input in claim 1, of the first sensactor 27 and the second feedback loop 49 links the negative output 39 of the differential amplifier means 25 with the balanced input 45, also called the third feedback input in claim 1, of the second sensactor 29.

According to the invention the physical quantity measuring unit 21 furthermore comprises a third feedback loop 53 linking a common mode output 55 of the fully differential amplifier means 25 with the sensing means 25 in particular with a common mode feedback input 57 and 59 of the first and second sensactor 27 and 29, also called second and fourth feedback input in claim 1.

In this embodiment, each of the sensactors 27, 29 comprises a sensor for sensing a scalar physical quantity. Preferably both sensors are identical, thus have the same transfer parameter $\alpha$ and the same differential transfer coefficient $\beta$ concerning the first and second feedback loop 47 and 49 and common mode feedback transfer parameter $\beta_{mc}$ concerning the third feedback loop 53. The parameters $\beta$ and $\beta_{mc}$ take into account the actuator parts of the sensactors 27 and 29. The arrangement of the sensactors 27 and 29 illustrated in Fig. 2, typically fabricated using micro technology techniques and assemblies, integrates a sensor part (transfer parameter $\alpha$) and an actuator part (reverse transfer coefficient $\beta$ and $\beta_{mc}$) able to generate amounts of the physical quantity sensed by the sensor. The sensactors 27 and 29 are placed within the mean distance $\pm d/2$ apart from the centre of the sensing means 23 along the direction $\vec{u}$. Thus the outputs 31, 33 provide an electrical signal dependant on scalar physical quantities to be measured at points $\pm\,d/2$, with respect to the center position 0. The sensactors 27 and 29 are thus arranged in the so called gradiometric arrangement.

In this embodiment of the invention the third feedback loop 53 is completed by a differential amplifier 61. One input 63 of this amplifier 61, here the negative one, is connected to the common mode output 55 of the fully differential amplifier means 55, whereas the second input 65 is linked to a reference potential $v_R$. Finally, the amplifier's 61 output 67 is connected to the second and fourth input 57 and 59.

The sensing means 23 of this embodiment thus provides two closely placed and well balanced sensors, in which the physical quantity to be captured by the sensors can be locally changed by the means of three local actuators, described above by the transfer coefficients $\beta$ and $\beta_{mc}$ that are able to convert incoming electrical signals coming from the three feedback loops 47, 49 and 53 and provided to the inputs 43 and 45 concerning the first two actuators and 57 and 59 concerning the third actuators, into amounts of the considered physical quantity closely placed within the two sensactors 27 and 29.

The device 21 which measures a scalar physical quantity but also its gradient along a given direction with its three feedback loops 47, 49 and 53 functions like described below. The following definitions will be used:

e corresponds to the value of a scalar quantity X at a given point P, e.g. point 0 in Figure 2, and $\vec{n}$ corresponds to the vector which is normal to a isolevel curve of the scalar quantity X passing by point P. Furthermore,

$$\overrightarrow{gradX} = \frac{\partial e}{\partial n}\,\vec{n}$$ is the mathematical definition of the gradient of X in any coordinate system. It corresponds to the rate of change of quantity X in the direction $\vec{n}$. In addition, $\frac{\partial e}{\partial n}(\vec{n}\cdot\vec{u})\vec{u}$ is the component of $\overrightarrow{gradX}$ upon an

axis oriented along a unit vector $\vec{u}$, e.g. the one illustrated in figure 2.

The gradient component upon the oriented axis in direction $\vec{u}$ can be derived form the scalar physical quantity measured by the sensors of the sensactors 27 and 29 at two points which are equidistant from P in direction $+\vec{u}$ and separated by the distance d. The values of the scalar physical quantity in these points, namely $e^+$ and $e^-$ with the + and - referring to directions $+\vec{u}$ and $-\vec{u}$ will be considered in the following.

Form the ratio $(e^+ - e^-)/d = \dfrac{e_d}{d}$, the gradient component $\dfrac{\partial e}{\partial n}(\vec{n} \cdot \vec{u})\vec{u}$ and $e^+ = e + \dfrac{d}{2} \cdot \dfrac{\partial e}{\partial u}$ in virtue of the Taylor expansion limited to the first order one obtains:

$$e^+ = e + \frac{d}{2} \frac{\partial e}{\partial n} \frac{\partial n}{\partial u}$$

and by geometry:

$$e^+ = e + \frac{d}{2} \frac{\partial e}{\partial n} (\vec{n} \cdot \vec{u}) \qquad \text{(equation 1)}$$

Similarly one gets:

$$e^- = e - \frac{d}{2} \frac{\partial e}{\partial n} (\vec{n} \cdot \vec{u}). \qquad \text{(equation 2)}$$

From equation 1 and 2, it follows that:

$$e = \frac{e^+ + e^-}{2}, \text{ and} \qquad \text{(equation 3)}$$

$$d \frac{\partial e}{\partial n} (\vec{n} \cdot \vec{u}) = e^+ - e^- \qquad \text{(equation 4),}$$

which shows how $e$ and $\dfrac{\partial e}{\partial n}(\vec{n} \cdot \vec{u})$ are related to the formal, usual definition of common mode and differential mode signals.

Using equation 1 and the transfer parameters α, ß and ß$_{mc}$ like defined above and illustrated in Figure 2, one obtains the following relationship for the signals at the sensactors outputs 33 and 31:

$$v^+ = \alpha \left[ e + \frac{d}{2} \frac{\partial e}{\partial n} (\vec{n} \cdot \vec{u}) + \beta_{mc} v_{mcR} + \beta v_s^- \right] \text{concerning output 33, and} \qquad \text{(equation 5)}$$

$$v^- = \alpha \left[ e - \frac{d}{2} \frac{\partial e}{\partial n} (\vec{n} \cdot \vec{u}) + \beta_{mc} v_{mcR} + \beta v_s^+ \right] \text{concerning output 31.} \qquad \text{(equation 6)}$$

$\dfrac{v^+}{\alpha}$ and $\dfrac{v^-}{\alpha}$ are the error signals, that are going to zero in the strong feed back limit.

The half sum also goes to zero, which implies:

$$2e + 2\beta_{mc} v_{mcR} + \beta\left(v_s^- + v_s^+\right) = 0 \qquad \text{(equation 7)}$$

and the difference also goes to zero, to give:

$$d \frac{\partial e}{\partial n}(\vec{n} \cdot \vec{u}) - \beta(v_s^+ - v_s^-) = 0 \qquad \text{(equation 8)}$$

It follows that:

$$\frac{\partial e}{\partial n}(\vec{n} \cdot \vec{u}) = \frac{\beta(v_s^+ - v_s^-)}{d} \qquad \text{(equation 9)}$$

and:

$$e = -\beta_{mc} v_{mcR} - \frac{\beta(v_s^- - v_s^+)}{2} \qquad \text{(equation 10)}$$

the last expression reduces to:

$$e = -\beta_{mc} v_{mcR} \qquad \text{(equation11)}$$

because $\frac{v_s^- + v_s^+}{2}$, which represents the common mode at the fully differential amplifier's output 55 output, goes to zero, due to both the common modes rejection of the amplifier 25 and to signals $v^+$ and $v^-$ at its inputs 37, 35 that are going to zero.

Thus the value e of the physical quantity X is directly proportional to the feedback signal of the common mode $v_{mcR}$. Depending on the application, the feedback parameter $\beta_{mc}$ can thus be chosen to match the specificity of the desired application.

The physical quantity measuring unit can be completed by a signal summing means connected to the differential outputs 39 and 41. The output of the signal summing means provides information about the gradient of the scalar unit, like explained further down.

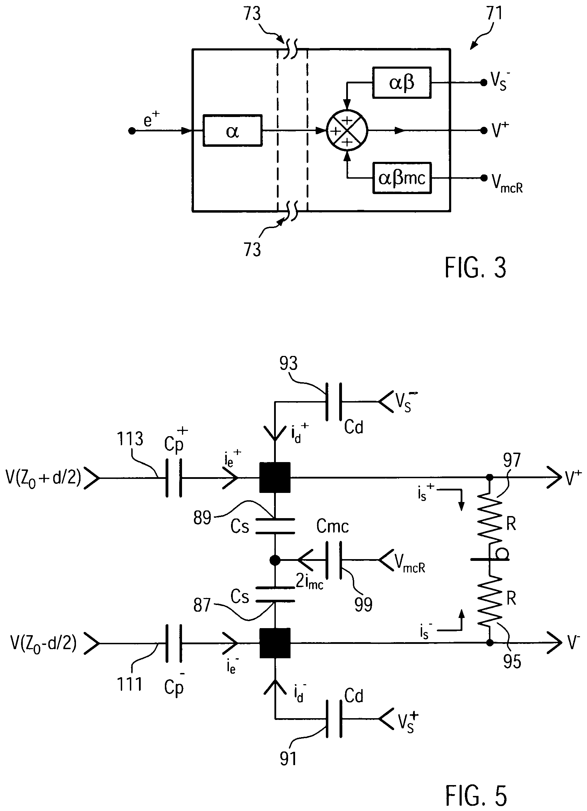

Figure 3 illustrates a sensactor topology according to a second embodiment. Two sensactors 71 like illustrated in Figure 3 can replace the first and second sensactor 27 and 29 of the first embodiment. The difference between the two is that in the second embodiment, the sensing part with the transfer parameter $\alpha$ can be spatially separated 73 from the actuating part with the feedback parameters $\beta$ and $\beta_{mc}$.

In this embodiment, no transformation of the feedback signal, back into the physical quantity is necessary. Thus, in this embodiment the error signals correspond to $v^+$ and $v^-$, which writes just the same as in the first embodiment, because it is always possible to express the new actuating parts in terms of what should be obtained using the first embodiment. It thus follows that the signals $v^+$ and $v^-$ just have the same formal expressions as previously, implying the same results. Nevertheless, the second embodiment has the advantage that the feedback loops can be localized on a printed circuit board, spaced away from the sensor part of the sensing means 23.

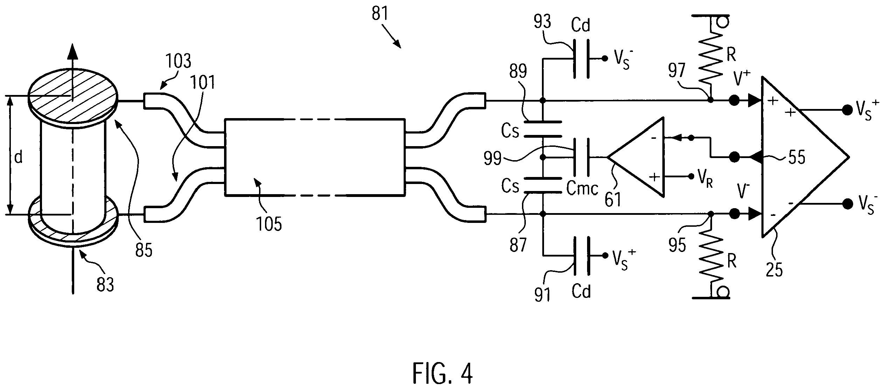

Figure 4 illustrates a free space voltmeter - E fieldmeter probe according to a third embodiment of the invention, using the topology of the second embodiment. Nevertheless, the topology of the first embodiment could also find its application. The physical quantity X in this embodiment is thus voltage. Features with reference numerals already used above are not repeated again in detail, but their description is incorporated herewith by reference.

The inventive voltmeter - E fieldmeter 81 illustrated in Figure 4 comprises two electrodes 83 and 85 placed within a distance d, with d typically ranging from about a few $\mu$m to a couple of meters, using an insulating material 87, in particular with a volume resistivity of $10^{13}$ $\Omega$.m or more. To optimize the topology, the thickness of the electrodes 83 and 85 which in this embodiment are circular metallic plates, is less d/2 and the square root of the plate's surface area is less than d/2.

Each electrode 83, 85 is wired to one pin of a signal capacitor 87 and 89 with capacitance $c_s$. The electrodes 83, 85 are furthermore connected to one pin of another capacitor 91 and 93 $c_d$ and to one pin of a high nominal value resistor 95 and 97 R, in particular with 1G$\Omega$ or more. Like mentioned above, the circuit is symmetric: the capacitors and the resistor have the same properties for the first and second electrode. The second pins of the capacitors 87 and 89 are connected to each other and the second pin of the resistors 95 and 97 is connected to a reference potential of the device 81.

The electrodes 83 and 85 form each one main node (first and second node), in the conventional meaning of standard circuit theory and the voltages $v^+$ and $v^-$ of the first and second node correspond to the first and second sensing means outputs like defined above. The resistors 95 and 97 are used to bias the inputs of the fully differential amplifier means 25.

The combined voltmeter E fieldmeter according to the third embodiment further comprise an additional capacitor 99 with capacitance $c_{MC}$, a pin of which is connected at the node linking the signal capacitors 87 and 89 while the other pin is connected to the output of a differential amplifier 61 receiving the common mode feedback signal 55 and the reference voltage.

Figure 4 furthermore illustrates guarded lines 101 and 103 as well as a common mode guard 105, but guarding connections to the fully differential amplifiers are not shown for clarity.

Figure 5 illustrates the electrical equivalent schema of the voltmeter - E fieldmeter according to the third embodiment of the invention to get the signal modelling.

Compared to Figure 4, two new capacitors 111 and 113 are introduced with capacitances $c_p^+$ and $c_p^-$. They are representative of the self capacitance of the metallic plates 83 and 85, in the meaning of electrostatic theory. The order of magnitude is typically 1 pF, and the value scales with the cubic root of the plate volume. Due to the schematic symmetry and to the superposition theorem, the current $2i_{mc}$ splits in equal values $i_{mc}$ through each capacitor $c_s$. Currents $i_d^+$, $i_d^-$ and $i_{mc}$ are the displacement currents to be considered as the acting part in the sensing means. Using the Kirchhoff law applied on the two marked (■) nodes 115 and 117, that is:

$$i_e^+ + i_d^+ + i_{mc} = i_s^+$$

$$i_e^- + i_d^- + i_{mc} = i_s^-$$

these currents are flowing into the biasing resistors 95 and 97 R which give rise to the voltages $v^+$ and $v^-$. Since these values are forced to zero in the strong feedback limit, the $i_e^+$ and $i_e^-$ voltages can then be written as:

$$i_e^+ = jc_p^+ \omega v\left(z_o + \frac{d}{2}\right) = jc_p^+ \omega\left(v(z_o) + \frac{d}{2}\frac{\partial v}{\partial z}\Big|_{z_o}\right)$$

$$i_e^- = jc_p^- \omega v\left(z_o - \frac{d}{2}\right) = jc_p^- \omega\left(v(z_o) - \frac{d}{2}\frac{\partial v}{\partial z}\Big|_{z_o}\right)$$

where $\omega$ is the signal pulsation and $j^2$ = -1. The common and differential modes are then introduced to give:

$i_e^+ - i_e^- = jc_p^- \omega d \frac{\partial v}{\partial z}\Big|_{z_o}$ and $\frac{i_e^+ + i_e^-}{2} = jc_p^- \omega v(z_o)$ in the practical case $c_p^+ = c_p^-$.

With the above arguments, one gets the other equations:

$$i_d^+ = jc_d \omega v_s^-, \qquad\qquad i_d^- = jc_d \omega v_s^+$$

and

$$i_{mc} = j\frac{c_s c_{mc}}{c_s + c_{mc}} v_{mcR} \approx jc_{mv} v_{mcR}, \text{ if } c_s \gg c_{mc}$$

By comparing those equations with equations 7 to 11 described above, one obtains:

$$jc_d\omega(v_s^+ - v_s^-) = jc_p\omega d\frac{\partial v}{\partial z}\Big|_{z_o} \text{ and } jc_p\omega v(z_o) = j\frac{c_s c_{mc}}{c_s + c_{mc}}\omega v_{mcR} \cong jc_{mc}\omega v_{mcR}$$

Thus, the $\beta$ and $\beta_{mc}$ parameters of the innovative topology in this embodiment of the inventive voltmeter E fieldmeter can be written as

$$\frac{\partial v}{\partial z}\Big|_{z_o} = \frac{\beta}{d}(v_s^+ - v_s^-) = -\frac{c_d}{c_p}\left(v_s^+ - v_s^-\right) \Rightarrow \beta = \frac{c_d}{c_p}$$

and

$$v(z_o) = -\beta_{mc}v_{mcR} = \frac{c_s c_{mc}}{c_p(c_s + c_{mc})}v_{mcR} \Rightarrow \beta_{mc} = -\frac{c_s c_{mc}}{c_p(c_s + c_{mc})}$$

Because we are able to identify the $\beta$ and $\beta_{mc}$ parameters, this shows that the second embodiment and the first embodiment are equivalent.

Finally the physical quantity, here voltage, is thus obtained via the common mode signal (equation 11) and the gradient, thus the electric field via the differential signal (equation 9). Thus unlike the prior art both modes can be exploited. The present invention thus allows the measurement of an electric field with a large bandwidth including very low frequencies, high dynamic range and linearity, without making electrical contacts. Instead of voltage, e.g. temperature could be measured by the common mode and the flux be determined using the differential mode using corresponding sensing means.

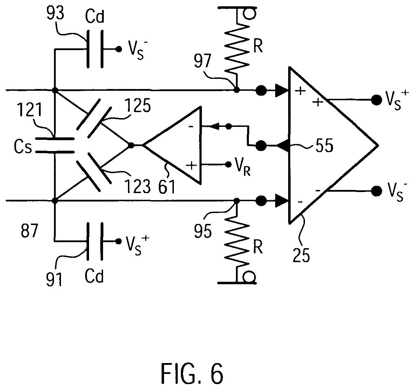

Figure 6 illustrates a variant of the third embodiment, in which the signal capacitors 87 and 89 are replaced by one capacitor 121 and the capacitor 99 by two capacitors 123 and 125.

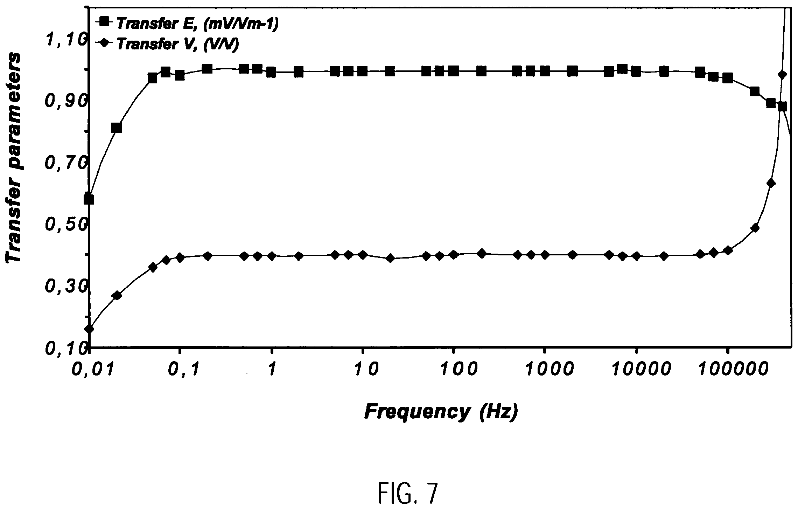

Figure 7 is a plot of measured transfer functions versus frequency both for the free space voltmeter output and the E-field meter output of a voltmeter and electric fieldmeter according to the invention. At low frequencies the 3 dB cutoff is close to 10 mHz, while at high frequencies it is at least 300 kHz. In the range 0,1 Hz to 100 kHz the responses are flat, with transfer coefficients of 0,4 V/V and 1 mV/Vm$^{-1}$ respectively for the voltage and for the E field time variations. Not shown here, time plots at the outputs also were obtained, allowing estimations of noise levels. In the full system bandwidth, rms values of about 5mV and 1V/m of noise, referred at the input are achieved estimated.

As described above, the present invention and the described embodiments relate to a combination of servo/feedback loops allowing differential sensactors to be controlled using a control unit simultaneously for the common mode and the differential mode of the measured signals. With the inventive topology, the invention improves features of the measuring process of physical quantities, in particular those concerning scalar physical quantities and their attached gradient. In this context, an important feature of the invention is the low level complexity of the topology as the fully differential and differential amplifying units can be implemented using standard integrated circuits such as operational amplifiers, instrumentation amplifiers, transconductance - transimpedance amplifiers, their choice being related to the exact nature of the electrical quantity provided at the sensors outputs (voltage, current, electrical charge or magnetic flux). In the same spirit, the output of chosen amplifiers is related to the exact nature of the electrical quantity fed to the actuators inputs.

## Claims

1. Physical quantity measuring unit (21), in particular a measuring unit of both a scalar physical quantity and its gradient, comprising:

   - a sensing means (23) comprising a first and a second sensactor (27,29), wherein the first sensactor is configured to provide a first output (31) and comprises a first and second feedback input (43,57) and the second sensactor is configured to provide a second output (33) and comprises a third and fourth feedback input (45,59),
   - a fully differential amplifier means (25) comprising differential outputs (39,41) and a common mode output (55), wherein the first and second output of the sensing means is connected to a first input (35) and a second input (37) of the fully differential amplifier means respectively,
   - two feedback loops (47,49) connecting the differential outputs of the fully differential amplifier means to the first and third feedback inputs with a signal sign inversion, and
- a third feedback loop (53) connecting the common mode output of the fully differential amplifier means with the second and fourth feedback inputs of the sensing means.

2. Physical quantity measuring unit according to claim 1, further comprising a differential amplifier between the common mode output of the fully differential amplifier means and the second and fourth feedback inputs of the sensing means.

3. Physical quantity measuring unit according to claim 1 or 2, wherein the signal sign inversion of the differential feedback loops is provided by a wiring reversal.

4. Physical quantity measuring device according to one of claims 1 to 3, further comprising a signal summing means with an inverting input, preferably an amplifying signal summing means, wherein the inputs of the signal summing means are coupled to the outputs of the amplifier means.

5. Physical quantity measuring device according to one of claims 1 to 4, wherein the first and the second sensactor have the same properties, in particular essentially have the same transfer parameter ($\alpha$) and/or feedback transfer parameters ($\beta$, $\beta_{mc}$).

6. Physical quantity measuring unit according to one of claims 1 to 5, configured such that the parameter $|\alpha\beta Ad| \gg$ 1, with $A_d$ being the differential gain of the fully differential amplifier means, and such that the parameter $|\alpha\beta_{mc}G_{mc}|$ $\gg$ 1, with $G_{mc}$ being the gain of the differential amplifier.

7. Physical quantity measuring unit according to one of claims 1 to 6, wherein the sensing means is configured such that the error signal formed from the first to third feedback loop can be inputted before the conversion of the physical quantity into an electric signal.

8. Physical quantity measuring unit according to one of claims 1 to 6, wherein the sensing means is configured such that the error signal formed from the first to third feedback loop can be inputted after the conversion of the physical quantity into an electric signal.

9. Device for measuring a voltage and an electric field comprising a physical quantity measuring unit according to one of claims 1 to 8, wherein the sensing means comprises a pair of metallic electrodes, in particular a metallic plate, more in particular a circular metallic plate, each electrode being in connection with the actuator of the sensactor, and the electrodes are coupled by at least one signal capacitor.

10. Device according to claim 9, wherein each electrodes is wired to

    - one pin of a signal capacitor $c_s$,
    - one pin of another capacitor $c_d$ and
    - one pin of a high nominal value resistor R, in particular with 1G$\Omega$ or more,

    and wherein the second pins of the capacitors $c_s$ are connected to each other and the second pin of the resistor is connected to a reference potential of the measuring unit.

11. Device according to claim 9 or 10, wherein the two electrodes are placed within a distance d, in particular the distance d ranging from about a few $\mu$m to a couple of meters, using an insulating material, in particular with a volume resistivity of $10^{13}$ $\Omega$.m or more.

12. Device according to claim 11, wherein the thickness of the electrodes, in particular the metallic circular plates, is less than d/2 and/or the square root of the plate is less than d/2.

13. Device according to one of claims 9 to 12, further comprising an additional capacitor $c_{MC}$, a pin of which is connected the node linking the signal capacitors $c_s$ while the other pin is connected to the output of the differential amplifier receiving the common mode feedback signal.

14. Device according to one of claims 9 to 13, further comprising a means for vibrating and/or rotating the sensing means.

**Patentansprüche**

1. Physikalische Größenmesseinheit (21), insbesondere eine Messeinheit für sowohl eine skalare physikalische Größe als auch ihren Gradienten, umfassend:

   ein Sensormittel (23), umfassend einen ersten und einen zweiten Sensaktor (47, 49), wobei der erste Sensaktor so konfiguriert ist, dass er einen ersten Ausgang (31) bietet und einen ersten und zweiten Rückführungseingang (43, 57) umfasst, und der zweite Sensaktor so konfiguriert ist, dass er einen zweiten Ausgang (33) bietet und einen dritten und vierten Rückführungseingang (45, 59) umfasst,
   ein vollständig differenzielles Verstärkermittel (25), umfassend differenzielle Ausgänge (39, 41) und einen Gleichtaktausgang (55), wobei der erste und zweite Ausgang des Sensormittels mit einem ersten Eingang (35) bzw. einem zweiten Eingang (37) des vollständig differenziellen Verstärkermittels verbunden ist,
   zwei Rückführungsschleifen (47, 49), welche die differenziellen Ausgänge des vollständig differenziellen Verstärkermittels mit dem ersten und dritten Rückführungseingang mit einer Umkehrung des Signalvorzeichens verbinden, und
   eine dritte Rückführungsschleife (53), die den Gleichtaktausgang des vollständig differenziellen Verstärkermittels mit dem zweiten und vierten Rückführungseingang des Sensormittels verbindet.

2. Physikalische Größenmesseinheit nach Anspruch 1, des Weiteren umfassend einen differenziellen Verstärker zwischen dem Gleichtaktausgang des vollständig differenziellen Verstärkermittels und dem zweiten und vierten Rückführungseingang des Sensormittels.

3. Physikalische Größenmesseinheit nach Anspruch 1 oder 2, wobei die Umkehrung des Signalvorzeichens der differenziellen Rückführungsschleifen durch eine Umpolung der Verdrahtung erfolgt.

4. Physikalische Größenmesseinheit nach einem der Ansprüche 1 bis 3, des Weiteren umfassend ein Signalsummierungsmittel mit einem invertierenden Eingang, vorzugsweise ein Verstärkungssignal-Summierungsmittel, wobei die Eingänge des Signalsummierungsmittels mit den Ausgängen des Verstärkermittels verbunden sind.

5. Physikalische Größenmesseinheit nach einem der Ansprüche 1 bis 4, wobei der erste und der zweite Sensaktor dieselben Eigenschaften aufweisen, und insbesondere vor allem dieselben Transferparameter ($\alpha$) und/oder Rückführungs-Transferparameter ($\beta$, $\beta_{mc}$) aufweisen.

6. Physikalische Größenmesseinheit nach einem der Ansprüche 1 bis 5, die so konfiguriert ist, dass der Parameter $|\alpha\beta A_d| \gg 1$, wobei $A_d$ die differenzielle Verstärkung des vollständig differenziellen Verstärkermittels ist, und so, dass der Parameter $|\alpha\beta_{mc}G_{mc}| \gg 1$, wobei $G_{mc}$ die Verstärkung des differenziellen Verstärker ist.

7. Physikalische Größenmesseinheit nach einem der Ansprüche 1 bis 6, wobei das Sensormittel so konfiguriert ist, dass das Fehlersignal, das von der ersten bis dritten Rückführungsschleife erzeugt wird, eingegeben werden kann, bevor die Umwandlung der physikalischen Größe in ein elektrisches Signal erfolgt.

8. Physikalische Größenmesseinheit nach einem der Ansprüche 1 bis 6, wobei das Sensormittel so konfiguriert ist, dass das Fehlersignal, das von der ersten bis dritten Rückführungsschleife erzeugt wird, eingegeben werden kann, nachdem die Umwandlung der physikalischen Größe in ein elektrisches Signal erfolgt ist.

9. Vorrichtung zum Messen einer Spannung und eines elektrischen Feldes, umfassend eine physikalische Größenmesseinheit nach einem der Ansprüche 1 bis 8, wobei das Sensormittel ein Paar aus metallischen Elektroden umfasst, insbesondere eine Metallplatte, und noch spezieller eine runde Metallplatte, wobei jede Elektrode in Verbindung mit dem Aktor des Sensaktors steht und die Elektroden durch mindestens einen Signalkondensator verbunden sind.

10. Vorrichtung nach Anspruch 9, wobei jede Elektrode verdrahtet ist mit
    einem Anschluss eines Signalkondensators $c_s$,
    einem Anschluss eines weiteren Signalkondensators $c_d$ und
    einem Anschluss eines Widerstands R mit einem hohen Nennwert, insbesondere mit 1 G$\Omega$ oder mehr,
    und wobei die zweiten Anschlüsse der Kondensatoren $c_s$ miteinander verbunden sind und der zweite Anschluss des Widerstands mit einem Referenzpotential der Messeinheit verbunden ist.

**11.** Vorrichtung nach Anspruch 9 oder 10, wobei die zwei Elektroden innerhalb einer Distanz d platziert werden und die Distanz d im Speziellen innerhalb des Bereichs von einigen wenigen $\mu$m bis zu einigen Metern liegt, wobei ein Isoliermaterial verwendet wird, insbesondere mit einem Durchgangswiderstand von $10^{13}$ $\Omega$m oder mehr.

**12.** Vorrichtung nach Anspruch 11, wobei die Dicke der Elektroden, insbesondere der runden Metallplatten, kleiner als d/2 ist und/oder die Quadratwurzel der Platte kleiner als d/2 ist.

**13.** Vorrichtung nach einem der Ansprüche 9 bis 12, des Weiteren umfassend einen zusätzlichen Kondensator $c_{MC}$, von dem ein Anschluss mit dem Knoten verbunden ist, der die Signalkondensatoren $c_s$ miteinander verbindet, während dessen anderer Anschluss mit dem Ausgang des differenziellen Verstärkers verbunden ist, der das Gleichtakt-Rückführungssignal empfängt.

**14.** Vorrichtung nach einem der Ansprüche 9 bis 13, des Weiteren umfassend ein Mittel zum Vibrierenlassen und/oder Drehen des Sensormittels.

## Revendications

**1.** Unité de mesure de quantité physique (21), en particulier une unité de mesure à la fois d'une quantité physique scalaire et de son gradient, comprenant :

un moyen de détection (23) comprenant un premier et un second capto-actionneur (27, 29), dans laquelle le premier capto-actionneur est configuré pour fournir une première sortie (31) et comprend une première et une deuxième entrée de rétroaction (43, 57) et le second capto-actionneur est configuré pour fournir une seconde sortie (33) et comprend une troisième et une quatrième entrée de rétroaction (45, 59),
un moyen amplificateur complètement différentiel (25) comprenant des sorties différentielles (39, 41) et une sortie en mode commun (55),
dans laquelle la première et la seconde sortie du moyen de détection sont raccordées à une première entrée (35) et à une seconde entrée (37) du moyen amplificateur complètement différentiel, respectivement
deux boucles de rétroaction (47, 49) raccordant les sorties différentielles du moyen amplificateur complètement différentiel aux première et troisième entrées de rétroaction avec une inversion de signe de signal, et
une troisième boucle de rétroaction (53) raccordant la sortie en mode commun du moyen amplificateur complètement différentiel aux deuxième et quatrième entrées de rétroaction du moyen de détection.

**2.** Unité de mesure de quantité physique selon la revendication 1, comprenant en outre un amplificateur différentiel entre la sortie en mode commun du moyen amplificateur complètement différentiel et les deuxième et quatrième entrée de rétroaction du moyen de détection.

**3.** Unité de mesure de quantité physique selon la revendication 1 ou 2, dans laquelle l'inversion de signe de signal des boucles de rétroaction différentielle est fourni par une inversion de câblage.

**4.** Dispositif de mesure de quantité physique selon l'une quelconque des revendications 1 à 3, comprenant en outre un moyen de sommation de signaux ayant une entrée inverseuse, de préférence un moyen de sommation de signaux amplificateurs, dans lequel les entrées du moyen de sommation de signaux sont couplées aux sorties du moyen amplificateur.

**5.** Dispositif de mesure de quantité physique selon l'une quelconque des revendications 1 à 4, dans lequel le premier et le second capto-actionneur présentent les mêmes propriétés, en particulier présentent essentiellement le même paramètre de transfert ($\alpha$) et/ou les mêmes paramètres de transfert de rétroaction ($\beta$, $\beta_{mc}$).

**6.** Unité de mesure de quantité physique selon l'une quelconque des revendications 1 à 5, configurée de telle sorte que le paramètre $|\alpha\beta A_d| \gg 1$, $A_d$ étant le gain différentiel du moyen amplificateur complètement différentiel et de telle sorte que le paramètre $|\alpha\beta_{mc}G_{mc}| \gg 1$, $G_{mc}$ étant le gain de l'amplificateur différentiel.

**7.** Unité de mesure de quantité physique selon l'une quelconque des revendications 1 à 6, dans laquelle le moyen de détection est configuré de telle sorte que le signal d'erreur formé à partir de la première jusqu'à la troisième boucle de rétroaction puisse être entré avant la conversion de la quantité physique en signal électrique.

**8.** Unité de mesure de quantité physique selon l'une quelconque des revendications 1 à 6, dans laquelle le moyen de détection est configuré de telle sorte que le signal d'erreur formé à partir de la première jusqu'à la troisième boucle de rétroaction puisse être entré après la conversion de la quantité physique en signal électrique.

**9.** Dispositif pour mesurer une tension et un champ électrique comprenant une unité de mesure de quantité physique selon l'une quelconque des revendications 1 à 8, dans lequel le moyen de détection comprend une paire d'électrodes métalliques, en particulier une plaque métallique, plus particulièrement une plaque métallique circulaire, chaque électrode étant en connexion avec l'actionneur du capto-actionneur et les électrodes sont couplées par au moins un condensateur de signal.

**10.** Dispositif selon la revendication 9, dans lequel chaque électrode est câblée à :

- une broche d'un condensateur de signal $c_s$,
- une broche d'un autre condensateur $c_d$ et
- une broche d'une résistance de valeur nominale élevée R, en particulier ayant une valeur égale ou supérieure à 1G$\Omega$,

et dans lequel les secondes broches des condensateurs $c_s$ sont raccordées l'une à l'autre et la seconde broche de la résistance est raccordée à un potentiel de référence de l'unité de mesure.

**11.** Dispositif selon la revendication 9 ou 10, dans lequel les deux électrodes sont placées à une certaine distance d, en particulier la distance d allant d'environ quelques $\mu$m à quelques mètres, à l'aide d'un matériau isolant, en particulier avec une résistivité de volume égale ou supérieure à $10^{13}$ $\Omega$.m.

**12.** Dispositif selon la revendication 11, dans lequel l'épaisseur des électrodes, en particulier des plaques métalliques circulaires, est inférieure à d/2 et la racine carrée de la plaque est inférieure à d/2.

**13.** Dispositif selon l'une quelconque des revendications 9 à 12, comprenant en outre un condensateur supplémentaire $c_{MC}$, dont une broche est raccordée au noeud reliant les condensateurs de signal $c_s$ tandis que l'autre broche est raccordée à la sortie de l'amplificateur différentiel recevant le signal de rétroaction en mode commun.

**14.** Dispositif selon l'une quelconque des revendications 9 à 13, comprenant en outre un moyen pour faire vibrer et/ou faire tourner le moyen de détection.

FIG. 1

(prior art)

FIG. 2

FIG. 3

FIG. 5

FIG. 4

FIG. 6

FIG. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 03048789 A

- WO 09036989 A

**Non-patent literature cited in the description**

- **V. FRICK et al.** CMOS Microsystem for AC current measurement with galvanic isolation. *Proceedings of IEEE Sensors 2002*

- IEEE International Conference on Sensors. IEEE, 12 June 2002, vol. 2, 1445-1450